# EUROPEAN PATENT APPLICATION

(11) **EP 4 851 343 A1**
(43) Date of publication of application: **09.12.2026**
(21) Application number: 25749037.5
(22) Date of filing: 24.01.2025
(51) Int. Cl.: C30B 25/12, C30B 25/10, C30B 25/14, C30B 29/36, C23C 16/458, C23C 16/54

(54) **SUSCEPTOR ASSEMBLY AND CHEMICAL VAPOR DEPOSITION APPARATUS**

(30) Priority: 30.01.2024 KR 20240014215; 04.01.2025 KR 20250001226
(71) Applicant: Tes Co., Ltd., Yongin-si, Gyeonggi-do 17162 (KR)
(72) Inventor: JUNG, Hyun-Chul, Yongin-si, Gyeonggi-do 17162 (KR); SUH, Dong-Sik, Yongin-si, Gyeonggi-do 17162 (KR); KIM, Jae-Hwan, Yongin-si, Gyeonggi-do 17162 (KR); CHO, Kwang-Il, Yongin-si, Gyeonggi-do 17162 (KR); SEO, Min-Ho, Yongin-si, Gyeonggi-do 17162 (KR)
(74) Representative: Jung, Minkyu
(86) International application number: PCT/KR2025/001536
(87) International publication number: WO 2025/165134

(57) **Abstract**

The present invention relates to a susceptor assembly and a chemical vapor deposition apparatus, and, more specifically, to a susceptor assembly and a chemical vapor deposition apparatus, which are capable of reducing temperature deviation of a substrate when a silicon carbide (SiC) film or the like is deposited on the substrate.

## Description

### TECHNICAL FIELD

The present invention relates to a susceptor assembly and a chemical vapor deposition apparatus, and more particularly, to a susceptor assembly and a chemical vapor deposition apparatus capable of reducing a temperature deviation of a substrate when depositing a silicon carbide (SiC) film or the like on the substrate.

### BACKGROUND ART

Recently, demand for SiC power semiconductor devices (SiC power devices) has rapidly increased, and the related market is expected to continue to grow.

Such an SiC power semiconductor device may be manufactured by disposing a substrate in a reaction chamber, supplying a mixed gas of a process gas and a carrier gas into the reaction chamber and thermally decomposing the mixed gas, thereby growing a silicon carbide (SiC) single crystal on the substrate seated on a susceptor.

A chemical vapor deposition apparatus according to the related art generally adopts a configuration including an induction heating coil spirally formed below a susceptor. In this case, the temperature of the induction heating coil decreases at a central portion, thereby causing a temperature deviation in a substrate seated on the susceptor, and thus it has been difficult to smoothly perform a process on the substrate.

### DISCLOSURE OF INVENTION

### TECHNICAL PROBLEM

An object of the present invention is to provide a chemical vapor deposition apparatus capable of reducing a temperature deviation of a substrate in order to solve the above-described problems.

### TECHNICAL SOLUTION

The object of the present invention described above may be achieved by a susceptor assembly including a susceptor having a body portion in which a recess into which a substrate or a satellite on which the substrate is seated is inserted is formed, and a protruding portion protruding downward from the body portion, and a heater for heating the susceptor.

Here, a diameter of the protruding portion may be 35 mm to 50 mm, and a height of the protruding portion may be smaller than the diameter.

In addition, the protruding portion may be detachably connected to the body portion.

Further, a cross-sectional area of the protruding portion may not be constant, and the cross-sectional area of the protruding portion may decrease as a distance from the body portion increases.

In addition, the susceptor assembly may further include a gas flow path penetrating the protruding portion or the body portion and connected to the recess.

In this case, the gas flow path may include a main gas flow path penetrating the protruding portion or the body portion, and a plurality of sub-gas flow paths branched from the main gas flow path and connected to the recess.

In addition, a diameter of the gas flow path may be 5 mm or less.

Meanwhile, the heater may be formed as an induction heating coil, and may include a first heater portion disposed below the body portion and a second heater portion disposed to surround the protruding portion.

In this case, the first heater portion may be configured in a shape bent and wound toward a central portion below the body portion, and the second heater portion may be disposed to surround the protruding portion multiple times along a vertical direction of the protruding portion.

Meanwhile, a cross section of the first heater portion may correspond to a rectangle elongated in a horizontal direction, and a cross section of the second heater portion may correspond to a square or a rectangle elongated in the horizontal direction.

In addition, a second spacing between the protruding portion and the second heater portion may be 1.0 times to 1.5 times a first spacing between the first heater portion and the body portion.

Further, the first spacing between the first heater portion and the body portion may be 5 mm to 20 mm.

In addition, cross-sectional areas of the first heater portion and the second heater portion may be 60 mm² to 250 mm².

Further, a coil forming the first heater portion may have a non-constant spacing.

Meanwhile, the spacing of the coil forming the first heater portion may be 3 mm to 30 mm.

In this case, the first heater portion and the second heater portion may be integrally formed.

In addition, a spacing between the second heater portion and the protruding portion may not be constant.

Meanwhile, the object of the present invention described above may be achieved by a chemical vapor deposition apparatus including a chamber, an inner chamber provided inside the chamber, a susceptor assembly provided inside the inner chamber, on which a substrate is seated, and configured to heat the substrate, and an upper plate provided inside the inner chamber and above the susceptor assembly and providing, between the upper plate and the susceptor assembly, a processing space in which the substrate is processed, wherein the susceptor assembly includes a susceptor having a body portion in which a recess into which the substrate or a satellite on which the substrate is seated is inserted is formed, and a protruding portion protruding downward from the body portion, and a heater for heating the susceptor.

Further, the heater may be formed as an induction heating coil, and may include a first heater portion disposed below the body portion and a second heater portion disposed to surround the protruding portion.

Meanwhile, a cross section of the first heater portion may correspond to a rectangle elongated in a horizontal direction, and a cross section of the second heater portion may correspond to a square or a rectangle elongated in the horizontal direction.

In addition, a second spacing between the protruding portion and the second heater portion may be 1.0 times to 1.5 times a first spacing between the first heater portion and the body portion.

Further, the body portion of the susceptor may be fixed to the chamber or the inner chamber, and a lower end portion of the protruding portion of the susceptor may be spaced apart from the chamber or the inner chamber.

### ADVANTAGEOUS EFFECTS

According to the present invention having the above-described configuration, by providing a protruding portion below a body portion of a susceptor and heating not only the body portion but also the protruding portion, a temperature deviation of a substrate may be reduced, thereby improving a thickness and doping uniformity of a film on the substrate.

### BRIEF DESCRIPTION OF DRAWINGS

FIG. 1 is a side cross-sectional view illustrating an internal configuration of a chemical vapor deposition apparatus according to an embodiment of the present invention,
FIG. 2 is a side view illustrating a susceptor assembly according to an embodiment,
FIG. 3 is a side view illustrating a susceptor assembly according to another embodiment,
FIG. 4 is a perspective view of a heater,
FIG. 5 is a plan view of the heater, and
FIG. 6 is a side view illustrating a susceptor assembly according to still another embodiment.

### MODE FOR INVENTION

Hereinafter, a structure of a chemical vapor deposition apparatus according to an embodiment of the present invention will be described in detail with reference to the drawings.

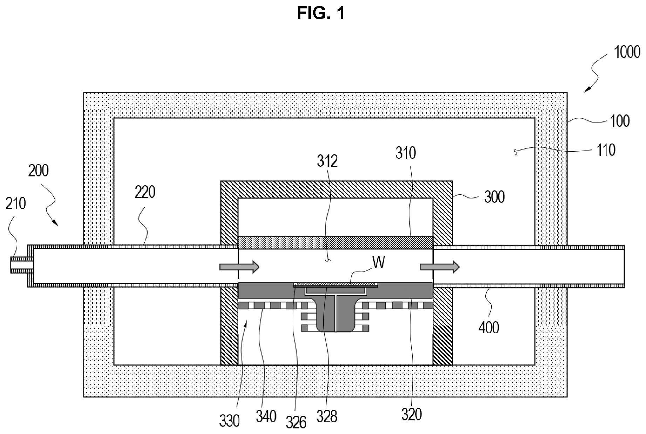

FIG. 1 is a side cross-sectional view illustrating an internal configuration of a chemical vapor deposition apparatus (1000) according to an embodiment of the present invention.

Referring to FIG. 1, the chemical vapor deposition apparatus (1000) may include a chamber (100). Various components may be provided in the chamber (100).

An accommodation space (110) may be provided inside the chamber (100), and an inner chamber (300) may be provided in the accommodation space (110).

A gas supply unit (200) may be connected to one side of the chamber (100). The gas supply unit (200) may serve to supply various process gases, purge gases, and the like toward a processing space (312).

The gas supply unit (200) may include a gas inlet pipe (220) extending from outside the chamber (100) to inside the chamber (100) and connected to the processing space (312). A supply port (210) through which gas is supplied may be formed in the gas inlet pipe (220) located outside the chamber (100).

Meanwhile, the inner chamber (300) may be provided inside the chamber (100), and the processing space (312) for a substrate (W) may be provided inside the inner chamber (300). By adopting a so-called double-chamber structure as described above, a possibility of particle contamination of the substrate (W) may be reduced, and a process on the substrate (W) may be performed more smoothly.

In addition, the inner chamber (300) may serve as a heat blocking member. That is, the inner chamber (300) may be disposed to surround a susceptor assembly (330) to be described below, and may be formed of carbon felt, graphite felt, or the like. Alternatively, the inner chamber (300) may be formed of graphite-coated carbon felt, carbon-coated graphite felt, or the like.

As described above, when the inner chamber (300) or the heat blocking member is provided, heat generated by a heater (340) of the susceptor assembly (330) is prevented from radiating to the outside of the inner chamber (300), and thus the processing space (312) may be heated more effectively.

Specifically, inside the inner chamber (300), there may be provided a susceptor assembly (330) on which the substrate (W), or a satellite (328) on which the substrate (W) is seated, is seated and which heats the substrate (W), and an upper plate (310) provided above the susceptor assembly (330) inside the inner chamber (300) and providing, between the upper plate (310) and the susceptor assembly (330), a processing space in which the substrate (W) is processed.

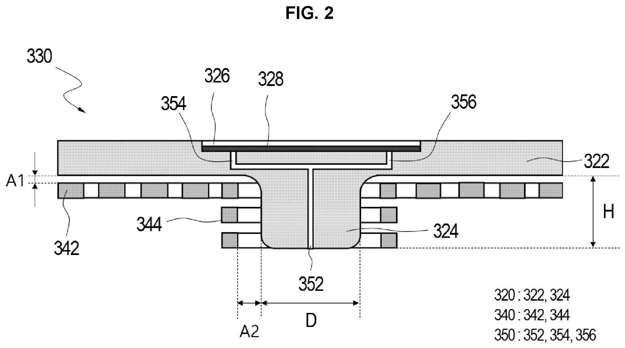

In addition, the susceptor assembly (330) may include a susceptor (320) having a body portion (322) (see FIG. 2) in which a recess (326) into which the substrate (W) or the satellite (328) on which the substrate (W) is seated is inserted is formed, and a protruding portion (324) (see FIG. 2) protruding downward from the body portion (322), and the heater (340) for heating the susceptor (320).

The chemical vapor deposition apparatus (1000) according to the present invention is an apparatus for depositing a silicon carbide (SiC) film on a surface of the substrate (W), and may supply a process gas or the like from a side of the processing space (312) by the gas supply unit (200), induce a laminar flow of gas inside the processing space (312), and grow silicon carbide (SiC) as a single crystal on an upper surface of the substrate (W).

One side of the inner chamber (300) may be connected to the gas inlet pipe (220), and a process gas or the like may be supplied through the gas inlet pipe (220).

Meanwhile, as described above, when a silicon carbide (SiC) film is deposited on the upper surface of the substrate (W), a process temperature is a high temperature of approximately 1600°C or higher. Accordingly, the upper plate (310) and the susceptor (320) constituting the processing space (312) may use graphite (Graphite), silicon carbide-coated graphite (SiC Coated Graphite), TaC-coated graphite (TaC Coated Graphite), or a silicon carbide material formed by a CVD sintering method, thereby increasing thermal stability and thermal conductivity, efficiently heating the substrate, and reducing power consumption.

FIG. 2 is a side view illustrating the susceptor assembly (330).

Referring to FIGS. 1 and 2, the processing space (312) is provided between the above-described upper plate (310) and the susceptor (320).

The susceptor (320) may include the body portion (322) and the protruding portion (324) formed to protrude downward from the body portion (322).

The recess (326) may be formed in an upper surface of the body portion (322), and the substrate (W) or the satellite (328) on which the substrate (W) is seated may be seated in the recess (326).

Meanwhile, when the substrate (W) or the satellite (328) is inserted into the recess (326), the substrate (W) or the satellite (328) may be rotatably provided on the susceptor (320).

That is, the susceptor assembly (330) may further include a gas flow path (350) penetrating the protruding portion (324) or the body portion (322) and connected to the recess (326), and may supply a levitation gas or the like toward a lower surface of the substrate (W) or the satellite (328) through the gas flow path (350) to rotate the substrate (W) or the satellite (328).

The substrate (W) may be rotated during a process on the substrate (W), such that a process gas or the like supplied from a side uniformly reacts over an entire surface of the substrate (W).

For example, as illustrated in FIG. 2, the gas flow path (350) may include a main gas flow path (352) penetrating the protruding portion (324) and extending upward from a lower portion of the protruding portion (324), and a plurality of sub-gas flow paths (354, 356) branched from the main gas flow path (352) and connected to the recess (326).

A levitation gas supplied from a levitation gas storage unit (not shown) may be injected into the recess (326) through the main gas flow path (352) and the sub-gas flow paths (354, 356) to rotate the substrate (W) or the satellite (328). In this case, the sub-gas flow paths (354, 356) may be connected while being inclined at a predetermined angle with respect to the recess (326). Accordingly, the substrate (W) or the satellite (328) may be rotated by the levitation gas injected through the sub-gas flow paths (354, 356).

A diameter of the gas flow path (350) may be appropriately determined, and may be determined to be, for example, 5 mm or less. When the diameter of the gas flow path (350) exceeds 5 mm, an amount of levitation gas required increases, and excessive levitation gas may reduce temperature uniformity in an edge region of the substrate (W).

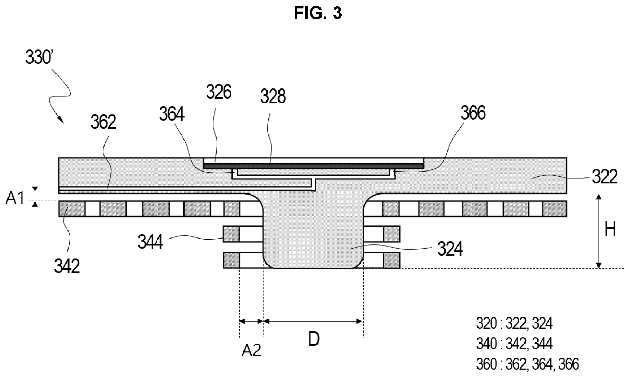

Meanwhile, FIG. 3 is a side view illustrating a susceptor assembly (330') according to another embodiment.

Referring to FIG. 3, in the susceptor assembly (330') according to the present embodiment, a main gas flow path (362) of a gas flow path (360) may extend through the body portion (322).

That is, the main gas flow path (362) may extend from a side surface of the body portion (322) to a central portion. The main gas flow path (362) may branch into a plurality of sub-gas flow paths (364, 366) at the central portion of the body portion (322).

Meanwhile, referring to FIGS. 1 and 2, a gas exhaust pipe (400) through which gas in the processing space (312) is exhausted may be connected to the other side of the inner chamber (300). The gas exhaust pipe (400) may extend outside the chamber (100) to exhaust the gas in the processing space (312) to the outside of the chamber (100).

In addition, the inner chamber (300) may include the heater (340) for heating the substrate (W) and the processing space (312) to a process temperature. The heater (340) may be provided below the susceptor (320) and may be formed as an induction heating coil. Since the induction heating coil may be used semi-permanently after installation, the induction heating coil has advantages in terms of maintenance and equipment operation costs.

A chemical vapor deposition apparatus according to the related art generally adopts a configuration including an induction heating coil spirally formed below the susceptor (320). In this case, the temperature of the induction heating coil decreases at a central portion, thereby causing a temperature deviation in the substrate (W), and thus it has been difficult to smoothly perform a process on the substrate (W).

In order to solve the above-described problem, the present invention includes the protruding portion (324) formed to protrude downward from the body portion (322) of the susceptor (320), and the heater (340) for heating the body portion (322) and the protruding portion (324).

That is, the heater (340) may include a first heater portion (342) disposed below the body portion (322), and a second heater portion (344) disposed to surround the protruding portion (324).

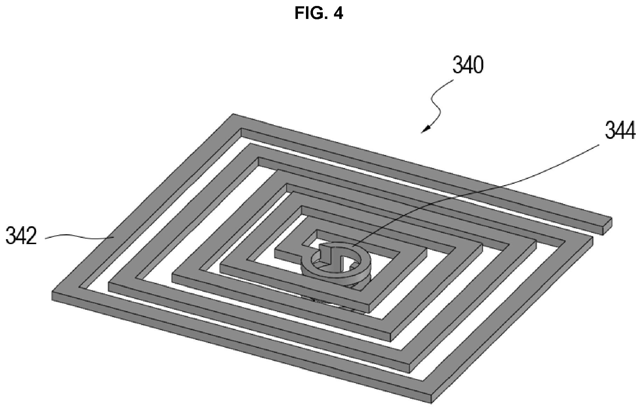

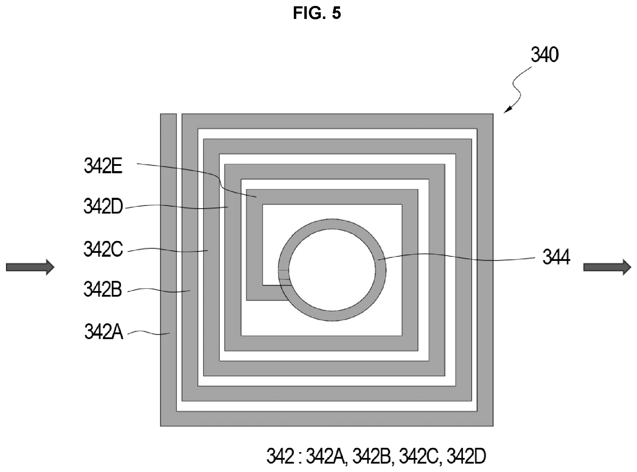

FIG. 4 is a perspective view of the heater (340), and FIG. 5 is a plan view of the heater (340).

Referring to FIGS. 2, 4, and 5, the first heater portion (342) may be disposed to be spaced apart from a lower surface of the body portion (322) by a predetermined first spacing (A1), and the second heater portion (344) may be disposed to be spaced apart from the protruding portion (324) by a predetermined second spacing (A2).

Accordingly, the body portion (322) may be heated by the first heater portion (342), while the protruding portion (324) is simultaneously heated by the second heater portion (344), thereby reducing a temperature deviation of the substrate (W).

The protruding portion (324) may be formed in a cylindrical shape, but is not limited thereto and may be appropriately modified. In addition, the protruding portion (324) may be integrally formed with the body portion (322), but the protruding portion (324) may be detachably connected to the body portion (322).

That is, when a size of the body portion (322) or a diameter of the substrate (W) changes, a protruding portion (324) having a different diameter (D) or height (H) may be mounted on the body portion (322) in correspondence with the change, thereby increasing a heat transfer effect caused by heating the protruding portion (324).

As illustrated in FIGS. 4 and 5, the first heater portion (342) may have a shape bent and wound toward a central portion below the body portion (322). In addition, the second heater portion (344) may be connected to the first heater portion (342) at a center of the first heater portion (342). The first heater portion (342) and the second heater portion (344) may be separately manufactured or may be integrally formed.

The second heater portion (344) may be disposed to surround the protruding portion (324) multiple times along a vertical direction of the protruding portion (324), and although the drawings illustrate that the second heater portion (344) has three layers or three turns from an upper side toward a lower side, the number of turns or layers may be appropriately adjusted according to the height of the protruding portion (324).

Meanwhile, as illustrated in FIG. 2, the first heater portion (342) may have a cross section in the form of a rectangle relatively elongated in a horizontal direction so as to heat the body portion (322) located above. Accordingly, an area of the first heater portion (342) facing the body portion (322) may be increased to effectively heat the body portion (322).

In addition, the second heater portion (344) may have a cross section in the form of a square or, although not illustrated in the drawings, a rectangle relatively elongated in a horizontal direction so as to heat the protruding portion (324).

In this case, cross-sectional areas of the first heater portion (342) and the second heater portion (344) may be 60 mm² to 250 mm².

When the cross-sectional areas of the first heater portion (342) and the second heater portion (344) are less than 60 mm², an amount of cooling water flowing in a coil of the heater portion decreases, and there is a risk of damage to the coil due to high-temperature water. On the other hand, when the cross-sectional areas of the first heater portion (342) and the second heater portion (344) exceed 250 mm², the number of turns by which the coil may be wound decreases in proportion to the increase in cross-sectional area, which may result in a decrease in induction heating efficiency.

Meanwhile, according to experiments conducted by the inventor, when the susceptor (320) is heated by the heater (340), it was found that a shape of the protruding portion (324) and a spacing between the heater (340) and the susceptor (320) are important.

For example, with respect to the diameter (D) and the height (H) of the protruding portion (324), it was found that heating efficiency provided by the protruding portion (324) is excellent when the height (H) of the protruding portion (324) is smaller than the diameter (D).

As an example, the diameter (D) of the protruding portion (324) may be approximately 35 mm to 50 mm, and the height (H) of the protruding portion (324) may be smaller than the diameter (D) of the protruding portion (324).

When the diameter (D) of the protruding portion (324) is less than 35 mm, a temperature at a central portion of the body portion (322) decreases, thereby reducing temperature uniformity, whereas when the diameter (D) of the protruding portion (324) exceeds 50 mm, excessive heat is conducted to central portions of the protruding portion (324) and the body portion (322), and a temperature at a central portion of the substrate (W) becomes higher than a temperature at an edge thereof, thereby reducing temperature uniformity.

In addition, with respect to a spacing between the heater (340) and the susceptor (320), it was found that heating efficiency provided by the body portion (322) and the protruding portion (324) is excellent when the second spacing (A2) between the protruding portion (324) and the second heater portion (344) is greater than the first spacing (A1) between the first heater portion (342) and the body portion (322).

For example, the second spacing (A2) between the protruding portion (324) and the second heater portion (344) may be 1.0 times to 1.5 times the first spacing (A1) between the first heater portion (342) and the body portion (322).

In this case, the first spacing (A1) between the first heater portion (342) and the body portion (322) may be approximately 5 mm to 20 mm, and the second spacing (A2) between the protruding portion (324) and the second heater portion (344) may be approximately 12 mm to 30 mm.

When the first spacing (A1) is less than 5 mm, induction heating efficiency for the body portion (322) increases, and a temperature at an edge of the body portion (322) becomes higher than a temperature at a central portion thereof, thereby reducing temperature uniformity. On the other hand, when the first spacing (A1) exceeds 20 mm, induction heating efficiency for the body portion (322) decreases, and a temperature at the edge of the body portion (322) decreases, thereby also reducing temperature uniformity.

In addition, when the second spacing (A2) is less than 1.0 times the first spacing (A1), induction heating efficiency from the second heater portion (344) to the protruding portion (324) increases, and excessive heat is conducted to central portions of the protruding portion (324) and the body portion (322), and a temperature at the central portion of the substrate (W) becomes higher than a temperature at the edge thereof, thereby reducing temperature uniformity.

On the other hand, when the second spacing (A2) exceeds 1.5 times the first spacing (A1), induction heating efficiency for the protruding portion (324) decreases, and an amount of heat conducted to the central portions of the protruding portion (324) and the body portion (322) decreases, and thus the temperature at the central portion of the substrate (W) becomes lower than the temperature at the edge thereof, thereby reducing temperature uniformity.

Meanwhile, as illustrated in FIG. 5, when the first heater portion (342) has a shape bent and wound toward the central portion, spacings of coils (342A, 342B, 342C, 342D, 342E) forming the first heater portion (342) may not be constant and may vary.

For example, the spacings of the coils (342A, 342B, 342C, 342D, 342E) forming the first heater portion (342) may be narrower at an edge and may become wider toward the central portion. As an example, the spacings of the coils (342A, 342B, 342C, 342D, 342E) forming the first heater portion (342) may be approximately 3 mm to 30 mm.

Meanwhile, in the plan view of FIG. 5, a flow of process gas with respect to the heater (340) is indicated by arrows.

That is, process gas enters from one side (or a left side) of the first heater portion (342), passes through the central portion of the heater (340), and passes through the other side (or a right side) of the first heater portion (342).

In this case, a temperature of the process gas initially entering a left edge of the first heater portion (342) may be relatively low. Accordingly, in order to compensate for the low temperature, the spacings of the coils (342A, 342B, 342C, 342D, 342E) forming the first heater portion (342) may be formed narrower at the edge to increase induction heating efficiency and improve temperature uniformity.

On the other hand, since the temperature of the process gas at the central portion of the first heater portion (342) is higher than at the edge, the spacings of the coils (342A, 342B, 342C, 342D, 342E) forming the first heater portion (342) may be formed wider at the central portion.

When the spacings of the coils (342A, 342B, 342C, 342D, 342E) forming the first heater portion (342) are less than 3 mm, manufacturing is difficult, whereas when the spacings of the coils (342A, 342B, 342C, 342D, 342E) forming the first heater portion (342) exceed 30 mm, induction heating efficiency may decrease.

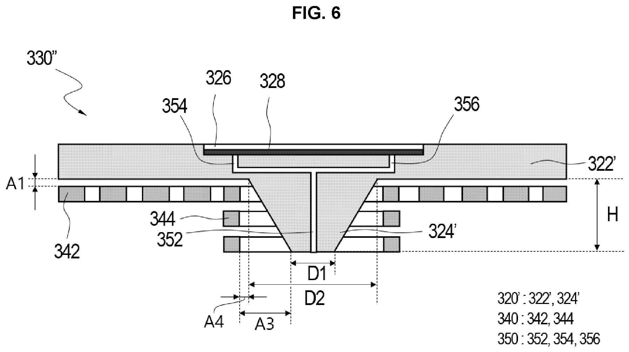

Meanwhile, FIG. 6 is a side view illustrating a susceptor assembly (330") according to another embodiment. In FIG. 6, the same reference numerals are used for the same components as those in FIG. 2 described above.

Referring to FIG. 6, a susceptor (320') may include a body portion (322') and a protruding portion (324') formed to protrude downward from the body portion (322').

In this case, the protruding portion (324') may be modified from the above-described cylindrical shape. For example, a diameter of the protruding portion (324') may vary non-constantly, or a cross-sectional area of the protruding portion (324') may vary non-constantly.

That is, in the cases of FIGS. 2 and 3 described above, the protruding portion (324) may be manufactured in a cylindrical shape and may have a constant cross-sectional area or diameter.

However, in the present embodiment, the protruding portion (324') may be manufactured in a form having a non-constant cross-sectional area or a non-constant diameter.

For example, as illustrated in FIG. 6, a cross-sectional area of the protruding portion (324') may decrease as a distance from the body portion (322') increases. Alternatively, diameters (D2, D1) of the protruding portion (324') may decrease as a distance from the body portion (322') increases. That is, a diameter (D1) of a lower end portion of the protruding portion (324') may be smaller than a diameter (D2) of an upper end portion of the protruding portion (324').

In addition, although not illustrated in the drawings, a cross-sectional area or a diameter of the protruding portion (324') may increase as a distance from the body portion (322') increases. Such a change in cross-sectional area or diameter may steadily increase or steadily decrease, and furthermore, the cross-sectional area or diameter may vary irregularly.

In addition, when the above-described configuration is provided, a spacing between the second heater portion (344) and the protruding portion (324') may not be constant.

For example, as illustrated in FIG. 6, a third spacing (A3) between the lower end portion of the protruding portion (324') and the second heater portion (344) may be different from a fourth spacing (A4) between the upper end portion of the protruding portion (324') and the second heater portion (344).

In the embodiment of FIG. 6, the third spacing (A3) between the lower end portion of the protruding portion (324') and the second heater portion (344) may be greater than the fourth spacing (A4) between the upper end portion of the protruding portion (324') and the second heater portion (344). However, this is merely an example, and the spacing between the protruding portion (324') and the second heater portion (344) may steadily increase or steadily decrease, and furthermore, may vary irregularly.

As in the present embodiment, by adjusting the cross-sectional area of the protruding portion (324') or the spacing from the second heater portion (344), excessive heat may be prevented from being conducted to a central portion of the body portion (322') such that a temperature at a central portion of the substrate (W) becomes higher than a temperature at an edge thereof. Accordingly, temperature uniformity in heating the substrate (W) may be improved.

Meanwhile, the susceptor assemblies (330, 330', 330") according to the embodiments of the present invention described above are of a type in which the body portions (322, 322') of the susceptors (320, 320') are fixedly supported by the chamber (100) or the inner chamber (300). Accordingly, the lower end portions of the protruding portions (324, 324') are not supported by any portion of the chamber (100) or the inner chamber (300) and have a spaced-apart structure, such that heat of the susceptors (320, 320') is not lost through the protruding portion (324).

The protruding portions (324, 324') of the susceptor assemblies (330, 330', 330") may be distinguished from a rotation shaft of a rotatable susceptor according to the related art.

Meanwhile, although not illustrated in the drawings of the present specification, a plurality of auxiliary heaters capable of individually controlling a temperature for each zone along a flow direction of process gas may be further provided above the upper plate (310) in order to reduce a temperature deviation caused by a flow of process gas in the processing space (312).

Further, in an embodiment, the auxiliary heaters may be formed as resistance heating heaters. This is because, when the auxiliary heaters are formed as induction heating heaters, magnetic field interference with the lower induction heating coil may occur.

In addition, a single induction coil surrounding both upper and lower portions of the processing space (312) may be used to prevent magnetic field interference between upper and lower induction coils. However, such a structure may make it difficult to maintain the inside of the processing space (312) even when a lid of the chamber is opened and closed. Accordingly, in an embodiment, the auxiliary heaters are preferably formed as resistance heating heaters.

Although the preferred embodiments of the present invention have been described above, those skilled in the art may variously modify and change the present invention without departing from the spirit and scope of the present invention set forth in the claims described below. Therefore, if a modified embodiment basically includes the elements of the claims of the present invention, the modified embodiment should be regarded as being included in the technical scope of the present invention.

### INDUSTRIAL APPLICABILITY

The present invention relates to a susceptor assembly and a chemical vapor deposition apparatus, and more particularly, to a susceptor assembly and a chemical vapor deposition apparatus capable of reducing a temperature deviation of a substrate when depositing a silicon carbide (SiC) film or the like on the substrate.

## Claims

1. A susceptor assembly comprising:
a susceptor including a body portion in which a recess into which a substrate or a satellite on which the substrate is seated is inserted is formed, and a protruding portion protruding downward from the body portion; and
a heater configured to heat the susceptor.

2. The susceptor assembly of claim 1, wherein a diameter of the protruding portion is 35 mm to 50 mm, and a height of the protruding portion is smaller than the diameter.

3. The susceptor assembly of claim 1, wherein the protruding portion is detachably connected to the body portion.

4. The susceptor assembly of claim 1, wherein a cross-sectional area or a diameter of the protruding portion is not constant.

5. The susceptor assembly of claim 4, wherein the cross-sectional area or the diameter of the protruding portion decreases as a distance from the body portion increases.

6. The susceptor assembly of claim 1, further comprising a gas flow path penetrating the protruding portion or the body portion and connected to the recess.

7. The susceptor assembly of claim 6, wherein the gas flow path includes a main gas flow path penetrating the protruding portion or the body portion, and a plurality of sub-gas flow paths branched from the main gas flow path and connected to the recess.

8. The susceptor assembly of claim 7, wherein a diameter of the gas flow path is 5 mm or less.

9. The susceptor assembly of claim 1, wherein the heater is formed as an induction heating coil, and the heater includes a first heater portion disposed below the body portion and a second heater portion disposed to surround the protruding portion.

10. The susceptor assembly of claim 9, wherein the first heater portion is configured in a shape bent and wound toward a central portion below the body portion, and the second heater portion is disposed to surround the protruding portion multiple times along a vertical direction of the protruding portion.

11. The susceptor assembly of claim 9, wherein a cross section of the first heater portion corresponds to a rectangle elongated in a horizontal direction, and a cross section of the second heater portion corresponds to a square or a rectangle elongated in the horizontal direction.

12. The susceptor assembly of claim 9, wherein a second spacing between the protruding portion and the second heater portion is 1.0 times to 1.5 times a first spacing between the first heater portion and the body portion.

13. The susceptor assembly of claim 9, wherein a first spacing between the first heater portion and the body portion is 5 mm to 20 mm.

14. The susceptor assembly of claim 9, wherein cross-sectional areas of the first heater portion and the second heater portion are 60 mm² to 250 mm².

15. The susceptor assembly of claim 9, wherein a coil forming the first heater portion has a non-constant spacing.

16. The susceptor assembly of claim 15, wherein a spacing of the coil forming the first heater portion is 3 mm to 30 mm.

17. The susceptor assembly of claim 9, wherein the first heater portion and the second heater portion are integrally formed.

18. The susceptor assembly of claim 9, wherein a spacing between the second heater portion and the protruding portion is not constant.

19. A chemical vapor deposition apparatus comprising:
a chamber;
an inner chamber provided inside the chamber;
a susceptor assembly provided inside the inner chamber, on which a substrate is seated, and configured to heat the substrate; and
an upper plate provided inside the inner chamber and above the susceptor assembly, and providing, between the upper plate and the susceptor assembly, a processing space in which the substrate is processed,
wherein the susceptor assembly includes a susceptor having a body portion in which a recess into which the substrate or a satellite on which the substrate is seated is inserted is formed, and a protruding portion protruding downward from the body portion, and a heater configured to heat the susceptor.

20. The chemical vapor deposition apparatus of claim 19, wherein the heater is formed as an induction heating coil, and the heater includes a first heater portion disposed below the body portion and a second heater portion disposed to surround the protruding portion.

21. The chemical vapor deposition apparatus of claim 20, wherein a cross section of the first heater portion corresponds to a rectangle elongated in a horizontal direction, and a cross section of the second heater portion corresponds to a square or a rectangle elongated in the horizontal direction.

22. The chemical vapor deposition apparatus of claim 20, wherein a second spacing between the protruding portion and the second heater portion is 1.0 times to 1.5 times a first spacing between the first heater portion and the body portion.

23. The chemical vapor deposition apparatus of claim 19, wherein the body portion is fixed to the chamber or the inner chamber, and a lower end portion of the protruding portion is disposed to be spaced apart from the chamber or the inner chamber.
